# EUROPÄISCHE PATENTSCHRIFT

(11) **EP 0 896 371 B1**
(45) Veröffentlichungstag und Bekanntmachung des Hinweises auf die Patenterteilung: **09.10.2013**
(21) Anmeldenummer: 98114641.8
(22) Anmeldetag: 04.08.1998
(51) Int. Cl.: H01L 31/048

(54) **Klimastabiles Dünnschicht-Bauelement**
Weather-resistant thin layer device
Composant à couches minces résistant aux effets climatiques

(30) Priorität: 05.08.1997 DE 19733913
(43) Veröffentlichungstag der Anmeldung: 10.02.1999
(73) Patentinhaber: Saint-Gobain Glass France S.A., 92400 Courbevoie (FR)
(72) Erfinder: Calwer, Hermann, 80634 München (DE)
(74) Vertreter: Gebauer, Dieter Edmund

(56) Entgegenhaltungen:
- EP-A- 0 321 083
- WO-A-95/03631
- US-A- 4 633 032
- US-A- 5 022 930

## Beschreibung

Die vorliegende Erfindung betrifft einen Randaufbau für feuchtigkeitsempfindliche Dünnschicht-Bauelemente, wie beispielsweise Solarmodule, flache Bildschirme oder mittels feuchteundurchlässigem Glas bzw. Folien versiegelten auf Silizium basierenden Bauelementen.

Zur Verdeutlichung eines Anwendungsgebiets der Erfindung wird im folgenden zunächst beispielhaft der Aufbau von CIS-Dünnschicht-Solarmodulen erläutert. Diese Solarmodule bestehen im wesentlichen aus drei Bestandteilen: einer Molybdänrückelektrode von 0,5 bis 1 µm Dicke, einer p-leitenden Chalkopyritabsorberschicht von 1 bis 3 µm Dicke und einer n-leitenden ZnO Frontelektrode von 1 bis 2 µm Dicke. Nach der ganzflächigen Abscheidung dieser drei Filme auf einem Substrat (beispielsweise aus Fensterglas) erfolgt eine Unterteilung in Streifen, um eine Serienverschaltung benachbarter Zellenstreifen zu realisieren. Nach der Dotierung wird das komplett verschaltete Halbleiterschichtpacket mit einer Frontglasscheibe geschützt, die mittels einer Kunststofffolie auflaminiert wird. Über den Rand, d.h. an den Schmalseiten des CIS-Dünnschicht-Solarmoduls kann Feuchtigkeit eindringen, die den Wirkungsgrad des Solarmoduls herabsetzt.

Die Ausbildung einer wetterbeständigen Verkapselung ist daher äußerst wichtig für die praktische Anwendung von Solarzellen, da eine Verminderung des Wirkungsgrades der Solarzellen aufgrund von Umwelteinflüssen zu Einbußen in der maximal erreichbaren Leistung oder zu einer Verringerung der Lebensdauer führt.

Aus EP 0 630 524 A1 (93 905 173.6) ist bekannt, daß Dünnschichtsolarzellen aus amorphem Silizium mit rückseitigen Kontaktstrukturen aus aluminiumdotiertem Zinkoxid ohne Lackschicht als Rückseitenabdeckung bereits eine sehr gute Feuchte/Wärmebständigkeit besitzen, so daß vorgeschlagen wird auf die Laminierung einer Rückseitenkunststofffolie oder - glasscheibe ebenso wie auf eine Versiegelung am Rand ganz zu verzichten.

Die US 4,633,032 A offenbart eine Solarzelle mit einem Glassubstrat. Ein Trockenmittel ist an der Rückseite angeordnet und schützt den Innenraum vor Feuchtigkeit.

Die US 5,022,930 A offenbart ein Dünnschichtsolarmodul mit einer Abdeckung zum Schutz vor Umwelteinflüssen. Der Zwischenraum zwischen Abdeckung und Frontelektrode enthält ein Trockenmittel zur Reduzierung der Feuchtigkeit.

Jedoch stellt gerade das Eindringen von Feuchtigkeit am Rand eines CIS-Dünnschicht-Solarmoduls, aber auch bei anderen Dünnschicht-Solarmodulen und ganz allgemein bei Dünnschicht-Bauelementen ein Problem dar, dessen Lösung weiterhin von größtem Interesse ist.

Der Erfindung liegt daher das Problem zugrunde, bei Dünnschicht-Bauelementen eine weitere Erhöhung der Klimastabilität zu erreichen und insbesondere das Eindringen von Feuchtigkeit zu verhindern.

Dieses Problem wird erfindungsgemäß bei den im Patentanspruch 1 und 5 beschriebenen Dünnschicht-Bauelementen gelöst. Vorteilhafte Ausgestaltungen der Erfindung ergeben sich aus den Unteransprüchen.

Der erfindungsgemäße Randaufbau kann universell für eine klimastabile Verkapselung von Dünnschicht-Bauelementen, beispielsweise flachen Bildschirmen verwendet werden. Besonders geeignet ist der erfindungsgemäße Randaufbau für Dünnschicht-Solarmodule, insbesondere CIS-Dünnschicht-Solarmodule.

Ein besonderer Vorteil besteht darin, daß durch die erfindungsgemäße Ausbildung des Randaufbaus die Eintrübung des Laminats (sogenanntes "fogging") wirksam verhindert wird, wenn als Laminatkleber beispielsweise EVA verwendet wird. Dieser Effekt, der durch den Feuchteangriff im Laminatkleber verursacht wird und der sich insbesondere bei Solarmodulen nachteilig auf den den Wirkungsgrad auswirkt, konnte bislang nicht verhindert werden.

Ein weiterer Vorteil des erfindungsgemäßen Randaufbaus besteht darin, daß beim Einsatz bei Dünnschicht-Solarmodulen auch die Korrosion der stromabführenden Lötbänder in den laminierten Solarmodulen wirksam verhindert wird.

Ein zentraler Gedanke besteht dabei darin, daß bei der vorliegenden Erfindung die Feuchtigkeit vor Eindiffusion in den Laminatverbund durch ein Trockenmittel, das am Rand des Dünnschicht-Bauelements angeordnet ist, quantitativ gebunden wird.

Im folgenden wird die Erfindung anhand von Ausführungsbeispielen unter Bezugnahme auf die beiliegenden Abbildungen genau beschrieben. Darin zeigt:
- Figur 1: eine Ausführungsform der klimastabilen Verkapselung eines Solarmoduls; und
- Figuren 2a und 2b: Ausführungsformen des erfindungsgemäßen Randaufbaus.

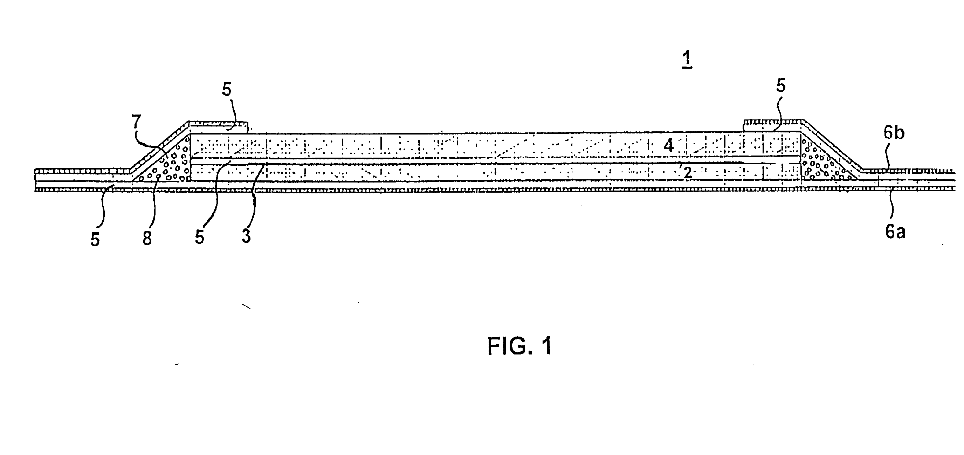

Figur 1 zeigt eine Ausführungsform (nicht Teil der Erfindung) des Randaufbaus zur klimastabilen Verkapselung eines Dünnschicht-Bauelements 1. Das in Figur 1 gezeigte Dünnschicht-Bauelement ist ein Solarmodul und besteht aus einem Glassubstrat 2, auf dem ein photoaktives Halbleiterpacket 3 ausgebildet ist. Auf der Lichteintrittsseite ist der Aufbau mit einem transparenten Frontglas 4 abgedeckt, das mit einem Laminatkleber 5, beispielsweise EVA aufgeklebt wird. Der Randaufbau ist bei diesem Ausführungsbeispiel unter Verwendung einer geeigneten Folie, beispielsweise einer Al-Tedlarfolie so ausgebildet, daß am Rand des Solarmoduls ein Hohlraum 7 gebildet ist, in dem ein Trockensmittel 8 angeordnet ist. Dazu ist das Solarmodul 1 auf einerersten Folie unter Verwendung eines Laminatklebers 5 aufgeklebt. Die Abmessungen der ersten Folie 6a sind etwas größer als die Abmessungen des Solarmoduls 1, so daß die erste Folie 6a allseitig übersteht. Eine zweite Folie 6b in Form von Streifen ist ebenfalls unter Verwendung eines Laminatsklebers 5 auf den überstehenden Bereichen der ersten Folie 6a aufgeklebt. Eine Längskante der streifenförmigen zweiten Folie 6b schließt mit der Kante der ersten Folie 6a bündig ab; die andere Längskante ist auf einen oberen Randabschnitt des Solarmoduls 1, wiederum unter Verwendung eines Laminatklebers 5, aufgeklebt.

Wie aus Figur 1 ersichtlich ist, entsteht somit ein dreieckförmiger Hohlraum zwischen den Schmalseiten des Solarmoduls 1, der ersten Folie 6a und der zweiten Folie 6b. Dieser Hohlraum ist mit einem Trockenmittel 8 gefüllt. Dieses Trockenmittel kann beispielsweise Silikatgel oder ein Molekularsieb sein. Der Verbund aus erster und zweiter Folie 6a bzw. 6b bildet eine Umrandung 6, die das Dünnschicht-Solarmodul 1 und das Trockenmittel 8 von allen Seiten ummantelt.

Wird das Dünnschicht-Bauelement Feuchtigkeit ausgesetzt, so wird das Trockenmittel diese Feuchtigkeit aufnehmen bzw. binden, so daß die Feuchtigkeit nicht in den Rand des Dünnschicht-Bauelements eindringen kann. Somit kann das Dünnschicht-Bauelement vor erhöhter Feuchtigkeitseinwirkung geschützt werden.

Ein Dünnschicht-Solarmodul mit dem Randaufbau genügt den Anforderungen unterschiedlicher Testverfahren, die entwickelt wurden, um Witterungseinflüsse zu überprüfen. Ein Verfahren, das die Klimabeständigkeit von Solarmodulen überprüfen soll, ist der sogenannte "Damp-Heat-Test". Nach der bekannten Norm IEC 1215 werden die Module dabei unter anderem für 1000 Stunden einer Temperatur von 85°C bei 85% relativer Luftfeuchte ausgesetzt. Dieser Klimatest gilt als bestanden, wenn der Wirkungsgradverlust des getesteten Solarmoduls 5% nicht übersteigt. Dünnschicht-Solarmodule mit dem Randaufbau bestehen den "Damp-Heat-Test" problemlos.

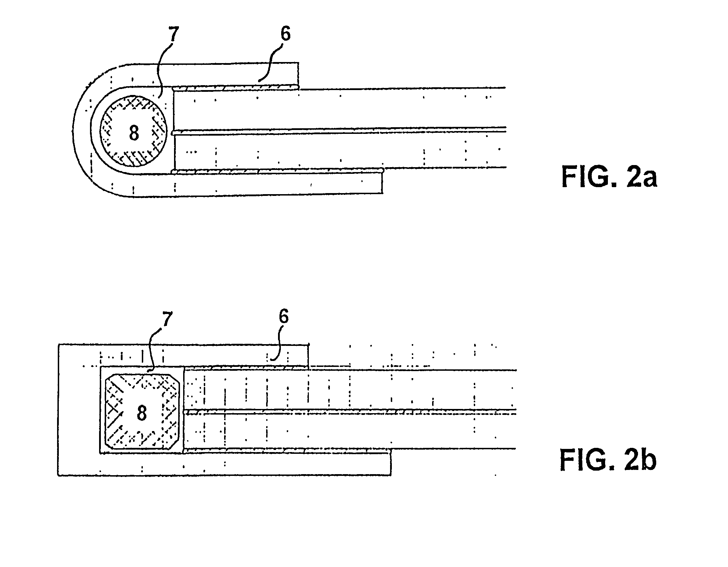

Ausführungsformen der Erfindung sind in Figur 2a und 2b dargestellt. Anstatt die Umrandung aus einer Folie aufzubauen, wird ein Rahmen mit U-Profil verwendet, dessen U-förmig Öffnung ungefähr mit der Dicke des Dünnschicht-Bauelements übereinstimmt. Das U-förmige Rahmenprofil wird seitlich auf die Ränder des klimastabil zu verkapselnden Moduls aufgeschoben und anschließend mit dem Modul 1 unter Verwendung eines Laminatklebers 5 verklebt. Auch hier wird der U-förmige Rahmen so angeordnet, daß zwischen Rahmen 6 und Dünnschicht-Bauelement 1 ein Hohlraum 7 entsteht. Der Hohlraum kann, je nach Wahl des U-förmigen Rahmenprofils rechteckig oder halbrund geformt sein. Auch bei diesem Ausführungsbeispiel ist der Hohlraum 7 mit einem Trockenmittel 8(z.B. Silikatgel, Molekularsiebe) gefüllt. Zudem kann ein Trockenmittel in Stangen- oder Strangform verwendet werden. Alternativ kann das Trockenmittel in ein Plastikmaterial, wie beispielsweise Butylkautschuk eingebettet werden, aus dem der U-förmige Rahmen hergestellt ist.

Der erfindungsgemäße Randaufbau wurde vorrangig anhand seiner Anwendung an einem Dünnschicht-Solarmodul erläutert. Jedoch ist der erfindungsgemäße Randaufbau nicht nur auf die klimastabile Verkapselung von Solarmodulen beschränkt. Vielmehr können auch andere Arten von Dünnschicht-Bauelementen, wie beispielsweise flache Bildschirme auf diese Weise klimastabil verkapselt werden.

## Patentansprüche

1. Dünnschicht-Bauelement mit einer Umrandung
**dadurch gekennzeichnet, dass** ein Hohlraum (7) zwischen den Schmalseiten des Dünnschicht-Bauelements (1) und der Umrandung (6) vorhanden ist und ein Trockenmittel (8) in dem Hohlraum (7) angeordnet ist, wobei die Umrandung (6) ein U-förmiges Rahmenprofil ist, das seitlich auf die Ränder des Dünnschicht-Bauelements (1) aufgebracht und mit einem Laminatkleber befestigt ist

2. Dünnschicht-Bauelement nach Anspruch 1,
**dadurch gekennzeichnet, dass** das U-förmige Rahmenprofil rechteckig oder halbrund geformt ist

3. Dünnschicht-Bauelement nach Anspruch 1 oder 2,
**dadurch gekennzeichnet, dass** das Trockenmittel (8) aus Silikatgel oder Molekularsieb besteht.

4. Dünnschicht-Bauelement nach einem der Ansprüche 1 bis 3,
**dadurch gekennzeichnet, dass** das Trockenmittel (8) in Strang- oder Stangenform vorliegt

5. Dünnschicht-Bauelement mit einer Umrandung
**dadurch gekennzeichnet, dass** die Umrandung (6) die Schmalseiten des Dünnschicht-Bauelements (1) umgibt und die Umrandung (6) ein U-förmiges Rahmenprofil ist, das aus einem Plastikmaterial hergestellt ist, in dem ein Trockenmittel eingebettet ist

6. Dünnschicht-Bauelement nach Anspruch 5,
**dadurch gekennzeichnet, dass** das Plastikmaterial Butylkautschuk ist.

7. Verwendung des Dünnschicht-Bauelements nach einem der Ansprüche 1 bis 6 in einem Dünnschicht-Solarmodul oder in flachen Bildschirmen.

## Claims

1. Thin-film device with a surround, **characterised in that** there is a cavity (7) between the narrow sides of the thin film module (1) and the surround (6) and a desiccant (8) is arranged in the cavity (7), where the surround (6) is a U-shaped frame that is attached from the side on the edges of the thin-film module (1) and fastened with a laminate adhesive.

2. Thin film device according to claim 1, **characterised in that** the U-shaped frame is rectangular or semi-circular.

3. Thin film device according to claim 1 or 2, **characterised in that** the desiccant (8) consists of a silica gel or a molecular sieve.

4. Thin film device according to one of the claims 1 to 3, **characterised in that** the desiccant (8) is present in extruded or rod form.

5. Thin-film device with a surround **characterized in that** the surround (6) surrounds the narrow sides of the thin film module (1) and the surround (6) is a U-shaped frame, which is made of a plastic material in which a desiccant is embedded.

6. Thin-film device according to claim 5, **characterized in that** the plastic material is butyl rubber.

7. Use of the thin-film device according to one of the claims 1 to 6 in a thin-film solar module or flat screens.

## Revendications

1. Composant à couches minces avec une bordure, **caractérisé en ce qu'**il existe une cavité (7) entre les côtés étroits du composant à couches minces (1) et la bordure (6) et un déshydratant (8) est arrangé dans la cavité (7), où la bordure (6) est un cadre en U qui est attaché latéralement sur les bords du composant à couches minces (1) et fixé avec un adhésif à stratifiés.

2. Composant à couches minces selon la revendication 1, **caractérisé en ce que** le cadre en U est rectangulaire ou en forme de demi-cercle.

3. Composant à couches minces selon la revendication 1 ou 2, **caractérisé en ce que** le déshydratant se compose de gel de silice ou de tamis moléculaire (8).

4. Composant à couches minces selon l'une des revendications 1 à 3, **caractérisé en ce que** le déshydratant (8) est présent sous forme de bande ou de tige.

5. Composant à couches minces avec une bordure, **caractérisé en ce que** la bordure (6) entoure les côtés du composant à couches minces (1) et la bordure (6) est un cadre en U, qui est fait d'un matériau en plastique dans lequel est incorporé un déshydratant.

6. Composant à couches minces selon la revendication 5, **caractérisé en ce que** le matériau en plastique est le caoutchouc butyle.

7. Utilisation du composant à couches minces selon l'une des revendications 1 à 6 dans un panneau solaire à couches minces ou des écrans plats.
